# EUROPEAN PATENT SPECIFICATION

(11) **EP 3 944 740 B1**
(45) Date of publication and mention of the grant of the patent: **19.06.2024**
(21) Application number: 20733614.0
(22) Date of filing: 18.06.2020
(51) Int. Cl.: H01L 29/66, H01L 29/06, H01L 29/40, H01L 29/417, H01L 29/423, H01L 29/739

(54) **METHOD OF FORMING ASYMMETRIC THICKNESS OXIDE TRENCHES**
VERFAHREN ZUR HERSTELLUNG VON OXIDGRÄBEN MIT ASYMMETRISCHER DICKE
PROCÉDÉ DE FORMATION DE TRANCHÉES D'OXYDE D'ÉPAISSEUR ASYMÉTRIQUE

(43) Date of publication of application: 02.02.2022
(73) Proprietor: Dynex Semiconductor Limited, Lincoln, Lincolnshire LN6 3LF (GB); Zhuzhou CRRC Times Semiconductor Co. Ltd, Shifeng District Zhuzhou Hunan (CN)
(72) Inventor: NGWENDSON, Luther-King, Lincolnshire LN6 9RT (GB); DEVINY, Ian, Lincolnshire LN6 8RH (GB); HUTCHINGS, John, Lincolnshire LN6 8AH (GB)
(74) Representative: Iqbal, Md Mash-Hud
(86) International application number: PCT/EP2020/066909
(87) International publication number: WO 2021/254618

(56) References cited:
- WO-A1-2018/215727
- US-A1- 2007 181 975
- US-A1- 2010 059 816

## Description

### Technical Field

The present disclosure relates to a method of manufacturing a semiconductor device having an insulation layer on selective trench sidewalls.

### Background

Many applications use fast switching, low loss insulated gate bipolar transistors (IGBTs) or metal oxide semiconductor field-effect transistors (MOSFETs). Trench gate IGBTs with uniform thin oxide have high turn on energy (E_{ON}) and turn off energy (E_{OFF}) losses due to high gate collector capacitance (Ccc) and gate emitter capacitance (C_{CG}).

Asymmetric trench oxide (thin oxide in a portion of one trench sidewall and thick oxide in the remaining areas) to improve performance in trench gate IGBTs and MOSFETs with Silicon and SiC. For example, within IGBTs it is advantageous to provide thick oxide in trench sidewall regions not used as a conduction channel and to provide thin oxide in regions where conduction channels are formed. This reduces the gate collector capacitance (Ccc) and gate emitter capacitance (C_{GE})and improves the switching speed. This also reduces the turn on energy loss (E_{ON}) and the turn off energy loss (E_{OFF}). In the case of SiC where electric field is 10X higher that silicon, the gate structure also enhance breakdown voltage (BV) capability.

Currently available processes for manufacturing a trench with a non-constant oxide layer are unreliable and result in low yields.

Traditional processing methods rely on using the photolithographic exposure dose to determine etch depth. Due to inherent inaccuracy, the etch depth has the tendency to vary significantly from one site to another across a wafer, from wafer to wafer, and between batches.

"IGBT with superior long-term switching behaviour by asymmetric trench oxide", Proceedings of the 30th International Symposium on Power Semiconductor Devices & ICs 2018, pp 24-27 relates to an IGBT chip with a trench having an asymmetric thick oxide layer and process for manufacturing the chip.

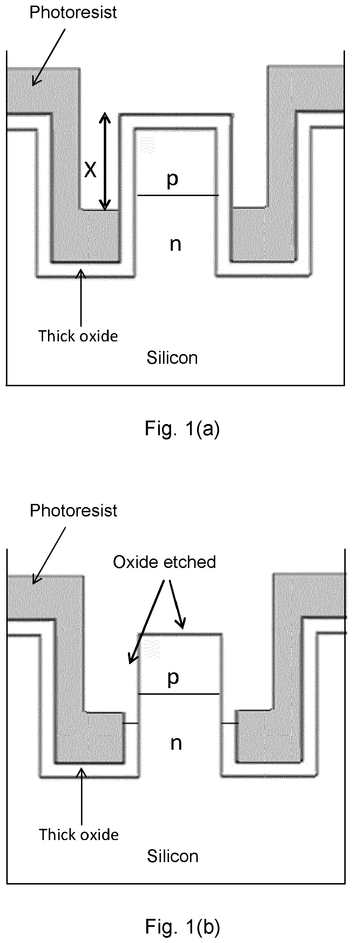

Figures 1(a) and 1(b) illustrate steps of manufacturing trenches with asymmetric insulation layers, according to the state of the art. The manufacturing process starts with a homogenous thick oxide insulation layer, covered by a photoresist material. The photoresist is exposed to remove the photoresist to a desired depth, *X*. The exposure dose is used to determine the depth *X*, and thus determines where thin gate oxide will be formed. An etch solution is then used to remove the thick oxide layer over all exposed areas.

This method of manufacture results in large variation of *X* from wafer to wafer and die to die on a wafer. There is also reduced integrity and stability of the photoresist within the trench during the etch process.

US 2010/059816 A1 discloses a method of manufacturing a semiconductor device having trenches, comprising a step of forming a photoresist reinforcement film on a silicon oxide film in the trenches.The photoresist reinforcement film prevents the silicon oxide film to be left from being removed by an etching solution entering the interface of a photoresist layer and the silicon oxide film in a wet etching process. The photoresist reinforcement film is preferably made of a silicon nitride film and the thickness is about 60 nm.

### Summary

Aspects and preferred features are set out in the accompanying claims.

According to the present disclosure, there is provided a method of manufacturing a semiconductor device having one or more trenches with an insulation according to claim 1.

Preferred embedments are disclosed in the dependent claims.

Forming a first insulation layer may comprise forming a thick insulation layer, and the hydrophilic layer may be deposited over the thick insulation layer, and forming a second insulation layer may comprise forming a thin insulation layer on the sidewall of the first side of the one or more trenches, wherein the thin insulation layer is thinner than the thick insulation layer.

Alternatively, forming a first insulation layer may comprise forming a thin insulation layer, and forming a second insulation layer may comprise forming a thick insulation layer over the thin insulation layer, wherein the thin insulation layer is thinner than the thick insulation layer.

The presently disclosed method of manufacturing a semiconductor device includes a step of depositing a hydrophilic layer. The hydrophilic layer means that the etchant, in the later step of performing a wet etch, uses capillary action to etch the insulation layer on the sidewalls, below the surface of the photoresist material. The capillary action etches down a channel between the hydrophilic layer and the material (for example, silicon) of the semiconductor device outside the trench. This also allows etching below the surface of the insulation layer, allowing deeper channels to be etched. Furthermore, this helps to achieve uniformity and consistency in both the etching process and the width and depth of the etched portion of the insulation layer. This also increases the controllability of the manufacturing process, in particular the width and depth of the etched portion.

The disclosed manufacturing process includes performing a wet etch that etches down a channel along the sidewall of the trench. This process facilitates the manufacture of devices having trenches with asymmetric or symmetric trench gate regions, having two different insulation layer thicknesses on a sidewall of a trench.

The herein disclosed manufacturing process improves uniformity of channel etch depth and width, and therefore improves electrical performance uniformity from die to die. The disclosed process also has improved process control and yield. The disclosed process results in a reduced number of defects caused by instability of photoresist during wet etch down deep trenches, compared to state-of-the-art methods of manufacturing trenches.

The method may be used to process devices of Silicon, SiC, GaN, and other materials used in semiconductor devices.

The method may be used to manufacture insulated gate bipolar transistors (IGBTs), metal oxide semiconductor field-effect transistors (MOSFETs), MOS-Controlled Thyristors, or other semiconductor power devices.

Depositing a photoresist material may be a two-step process that includes depositing a photoresist material and then exposing the hydrophilic layer on an upper region of a first side of the one or more trenches.

The method may further comprise depositing a filling material after growing the thin insulation layer.

The hydrophilic layer may comprise SiₓN_{y} (silicon nitride) with good wettability or a high degree of wetting The wettability modulates etch rate down trench side-walls, and enables uniformity of etch distance and repeatability of the process. If wettability is not sufficient, some areas will etch faster than others down the trench walls by the capillary action. A material with high degree of wetting improves the capillary action that etches down a channel. The wettability property of the hydrophilic layer allows accurate control of etch depth and ensures uniformity of the etch process down the etched channel.

The thickness of the hydrophilic layer mains integrity during the wet etch/capillary etch process.

The step of performing a wet etch may be carried out using a buffered oxide etch (BOE). The semiconductor device or wafer may be immersed in the BOE in order to etch the insulation layer along any exposed mesa region and trench sidewalls. Exposure to the bottom of deep trenches is difficult except for very wide trenches. The use of a wet etch means that exposure to the bottom of the trench is not required. The wet etch makes use of capillary action of the etch solution (such as BOE 7:1 HCL) to etch down the exposed sidewall and up the second trench sidewall to a desired distance.

The buffered oxide etch may comprise hydrofluoric (HF) acid. Hydrofluoric acid is a suitable solution for use in semiconductor manufacturing, and provides sufficient etch rate to make the process manufacturable.

Forming a thick insulation layer may comprise thermally growing a thick oxide layer using a local oxidation of silicon process.

Alternatively, forming a thick insulation layer may comprise depositing a thick oxide layer.

Depositing a thick oxide layer may be carried out using Tetraethyl Orthosilicate (TEOS) deposition. TEOS deposition is very conformal.

The thick insulation layer may have a thickness between 1800Å and 5000Å, whereby 1Å = 0.1nm.

Growing a thin insulation layer may comprise thermally growing a thin oxide layer at 900°C to 1100°C.

The thin insulation layer may have a thickness between 500Å to 1800Å.

The method may comprise manufacturing one or more trenches with an asymmetric insulation layer. The one or more trenches may have one sidewall with an insulation layer of two different thicknesses, and one sidewall with an insulation layer of constant thickness. The step of performing the wet etch may be used to etch along only one sidewall of the one or more trenches.

Alternatively or additionally, the method may comprise manufacturing one or more trenches with a symmetric insulation layer. The one or more trenches may have both sidewalls each with an insulation layer of two different thicknesses. Depositing a photoresist material may comprise exposing the hydrophilic layer on an upper region of two sides of the one or more trenches. The method may further comprise performing the wet etch process to etch the insulation layer on two sidewalls of the one or more trenches to a predetermined distance below a surface of the photoresist material, and growing a thin insulation layer on the two sidewalls of the one or more trenches.

The method may comprise manufacturing at least two trenches each with an insulation layer. A first trench may be separated from a second trench by a mesa region between the two trenches. The first side of the first trench may be adjacent to the first side of the second trench. Depositing a photoresist material may comprise exposing the hydrophilic layer in the mesa region between the first and second trenches.

The method may further comprise removing the hydrophilic layer in the mesa region between the two trenches. This allows the thick oxide in the mesa region to be removed by etching, as the thick oxide in the mesa region is therefore not protected by the hydrophilic layer. This also removes the hydrophilic layer above the thick oxide on the trench sidewall so that the thick oxide on the sidewall can be etched.

Removing the hydrophilic layer in the mesa region may comprise removing the hydrophilic layer such that a top surface of the hydrophilic layer is recessed relative to a surface of the thick oxide layer.

The method may further comprise performing a wet etch process to etch the insulation layer on the mesa region. This removes the thick insulation layer on the mesa region.

### Brief Description of the Drawings

The present disclosure will be understood, by way of example only, from the detailed description that follows and from the accompanying drawings in which:
Figures 1(a) and 1(b) illustrate steps of manufacturing trenches with asymmetric insulation layers, according to the state of the art;
Figures 2(a) to 2(j) illustrate steps of manufacturing trenches with asymmetric insulation layers, according to an embodiment of the disclosure;
Figure 3 illustrates schematically a semiconductor device having trenches manufactured using a method according to an embodiment of the disclosure;

### Detailed Description of the Preferred Embodiments

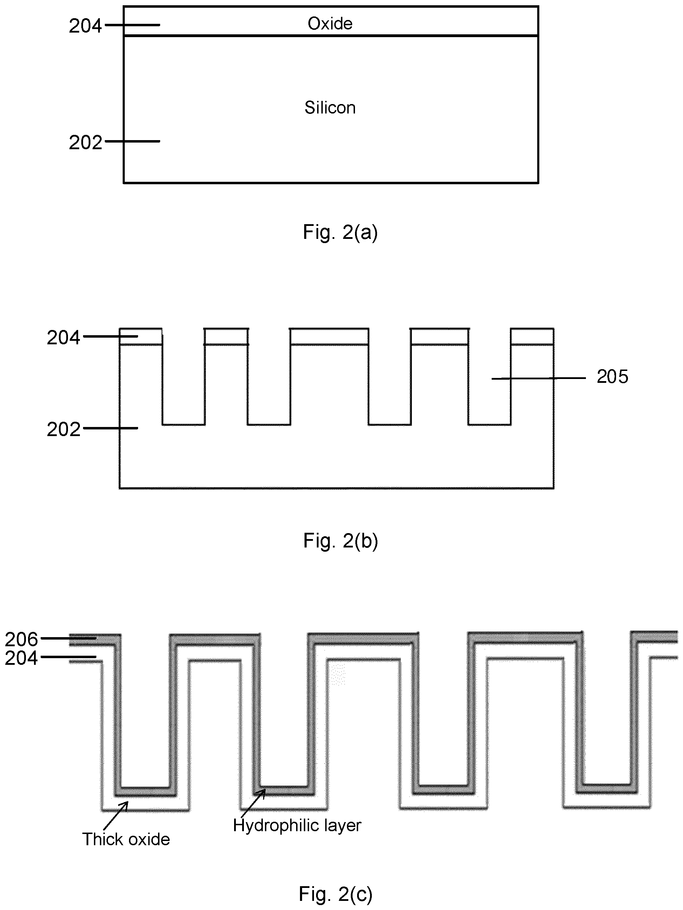

Figures 2(a) to 2(j) illustrate steps within the manufacturing process of trenches with asymmetric insulation layers, according to an embodiment of the disclosure.
Figure 2(a) illustrates the first step of manufacturing two trenches with asymmetric insulation layers, which is as follows:
   (a) Step 1
      - A thin oxide layer 204 is deposited on a silicon substrate 206. The thin oxide layer has thickness of approximately 500Å to 1800Å.
Figure 2(b) illustrates the second step of manufacturing two trenches, which is as follows:
   (b) Step 2
   - Photolithography and then a dry etch step using plasma source to form trenches to desired depth z in the silicon substrate 206. In this embodiment, the desired depth z of the trenches is 3µm to 6µm.
Figure 2(c) illustrates the third step of manufacturing two trenches, which is as follows:
   (c) Step 3
   - A thick oxide layer 204 is thermally grown or deposited on the sidewalls and bottom surface of the trenches. The thick oxide layer 204 may be deposited using TEOS. The thick oxide layer has a thickness of approximately 1800Å to 5000Å.
   - A hydrophilic layer 206 such as nitride is deposited over the oxide layer 204. The nitride layer 206 has a thickness of approximately 1000Å to 2500Å.

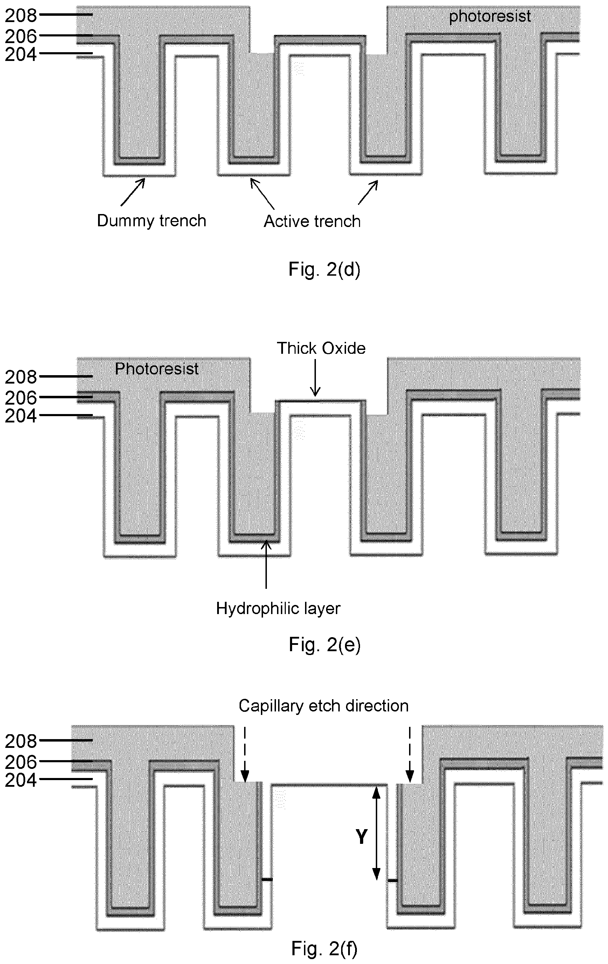

Figure 2(d) illustrates the fourth step of manufacturing two trenches, which is as follows:
   (d) Step 4
   - The trenches are filled with a photoresist material 208.
   - The photoresist 208 is deposited such that the hydrophilic layer 206 is exposed on a first side of each trench for which asymmetric oxide will be manufactured, and in the mesa region between trenches.
   - The first side of each trench (the side where the hydrophilic layer 206 is exposed) is the side of the trench that will be manufactured to have a thin oxide layer, whilst the side of each trench that will be manufactured to have thick oxide remains covered by the photoresist.
   - The thickness of the photoresist is 1.0µm to 1.5µm for a 1.5µm width trench.
Figure 2(e) illustrates the fifth step of manufacturing two trenches, which is as follows:
   (e) Step 5
   - An etch process is performed on the exposed hydrophilic layer 206. The etch process can be a wet or dry etch, and stops on the thick oxide layer 204 in the mesa region.
   - Since the hydrophilic layer 206 comprises nitride, the etch process may be done in plasma ambient (an atmosphere or environment of plasma, created by a mixture of gases) using CF4/HBr chemistry.
   - The hydrophilic layer 206 is etched such that the edges of the hydrophilic layer 206 are recessed relative to the surface of the thick oxide 204.
Figure 2(f) illustrates the sixth step of manufacturing two trenches, which is as follows:
   (f) Step 6
   - The whole wafer is immersed in a BOE (buffered oxide etch) such as 7:1 HF. The buffered oxide etchant etches the oxide layer 204 on the exposed mesa region and the trench sidewalls extending down from the exposed mesa region to a desired depth *Y* below the surface of the trench.
   - The hydrophilic layer 206 creates a capillary action so that the etchant etches the oxide layer 204 along the narrow channel between the hydrophilic layer itself 206 and the silicon 202.
   - The presence of the hydrophilic layer 206 allows control of the etch depth and uniformity of the etch process. The hydrophilic layer 206 reduces defects formed during the etch process.

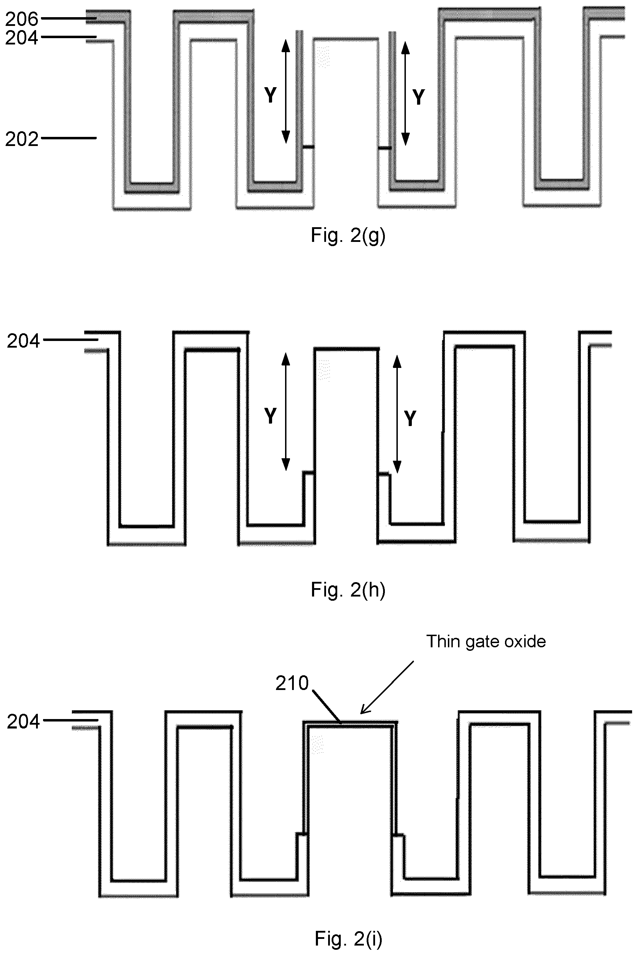

Figure 2(g) illustrates the seventh step of manufacturing two trenches, which is as follows:
   (g) Step 7
   - The photoresist is stripped (removed) using any suitable wet (such as hot phosphoric acid) or dry (such as a mixture of CF4 and HBr gases in a plasma etch chamber) chemistry.
Figure 2(h) illustrates the eighth step of manufacturing two trenches, which is as follows:
   (h) Step 8
   - The hydrophilic layer is stripped (removed) using any suitable wet or dry chemistry. This leaves the trenches having only oxide 204 on regions not exposed in Steps 4 and 5.
Figure 2(i) illustrates the ninth step of manufacturing two trenches, which is as follows:
   (i) Step 9
      - A thin oxide layer 210 is grown on the exposed silicon in a furnace step at 900°C to 1100°C. The thin oxide layer grows on the first side of each trench in which the hydrophilic layer was exposed in Step 4, and in the mesa region between the trenches.
      - The thin oxide layer has thickness of approximately 500Å to 1800Å.

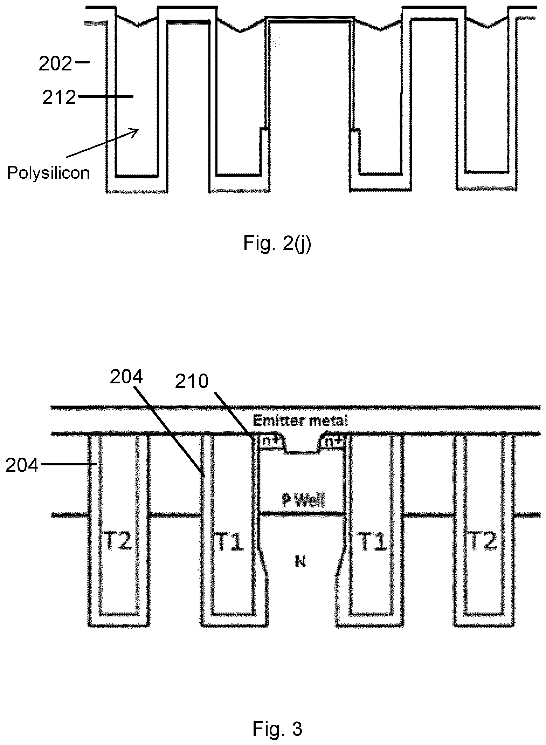

Figure 2(j) illustrates the tenth step of manufacturing two trenches, which is as follows:
   (j) Step 10
   - Polysilicon 212 is deposited to fill the trenches. The polysilicon 212 is planarised by etching the top of the polysilicon 212 to level off with the silicon 202 in the mesa region between the trenches.
Figure 3 illustrates schematically a semiconductor device having trenches manufactured using a method according to an embodiment of the disclosure. In this device, the active gates T1, each have asymmetric trench oxide insulation layers, whilst the dummy (or auxiliary trenches) T2 have symmetric thick oxide insulation layers.
   The active trenches T1 shown in this embodiment each have an asymmetric oxide. In this embodiment only the electron conduction channel region has thin oxide 210, and the remaining sidewall and bottom of each of the active trenches T1 have thick oxide 204. The thin oxide 210 in the channel region reduces the input capacitance (Cᵢₙ) and C_{GC}. This results in reduced gate charge and faster turn-off and turn-on times, therefore reducing E_{ON} and E_{OFF} respectively.
   Whilst the auxiliary trenches T2 are shown as having thick oxide insulation 204, alternatively the disclosed method could be used to manufacture a semiconductor device having auxiliary trenches with symmetric thin oxide or having variable oxide thickness.

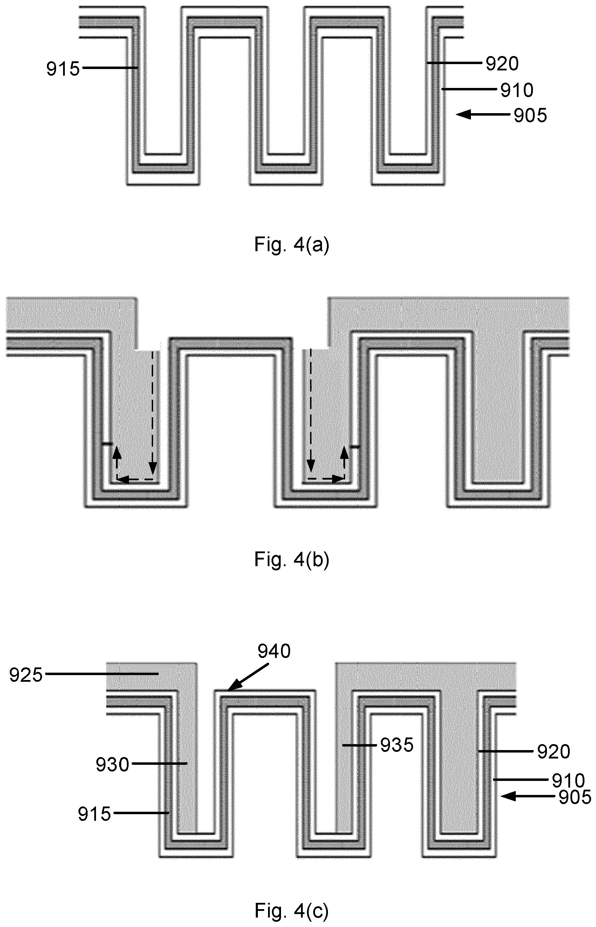

Figures 4(a) to 4(i) shows steps in the manufacturing method of a semiconductor device, according to an embodiment of the disclosure;
Figure 4(a) illustrates the first step of manufacturing the trenches of the semiconductor device, which is as follows:
   (a) Step 1
      - Trenches 905 are etched.
      - An initial oxide layer 910 is formed over the trenches. The initial oxide layer 910 is a sacrificial oxidation layer. It is an oxide layer created immediately after silicon etch to create trenches. The main purpose of this layer is to remove surface roughness created by the trench etch process. Traditionally, this oxide is later removed prior to formation of the thin gate oxide.
      - A hydrophilic layer 915 such as nitride is deposited over the initial oxide layer 910. The nitride layer 915 has a thickness of approximately 1000Å to 2500Å.
      - A thin oxide layer 920 is deposited using TEOS over the hydrophilic layer 915. The thin oxide layer 920 has thickness of approximately 500Å to 1800Å.
Figures 4(b) and 4(c) illustrates the second step of manufacturing the trenches of the semiconductor device, which is as follows:
   (b) Step 2
   - Photolithography is performed to apply a photoresist mask 925 that fills the trenches, where the mask ends in the centre of one trench 930 (for example, the active trench) and at least one other trench 935 (for example, a dummy trench). This leaves half of the active trench and the dummy trench exposed, as well as the mesa region between the trenches. The mask 925 may be applied in a two-step process as shown in which the mask is deposited and then etched to expose the TEOS 920.
   - The photoresist 925 is deposited such that the thin oxide layer 920 is exposed on a first side of each trench for which asymmetric oxide will be manufactured, and in the mesa region 940 between trenches.
   - The first side of each trench (the side where the thin oxide layer 920 is exposed) is the side of the trench that will be manufactured to have a thick oxide layer, whilst the side of each trench that will be manufactured to have thin oxide or oxide of different thickness remains covered by the photoresist.

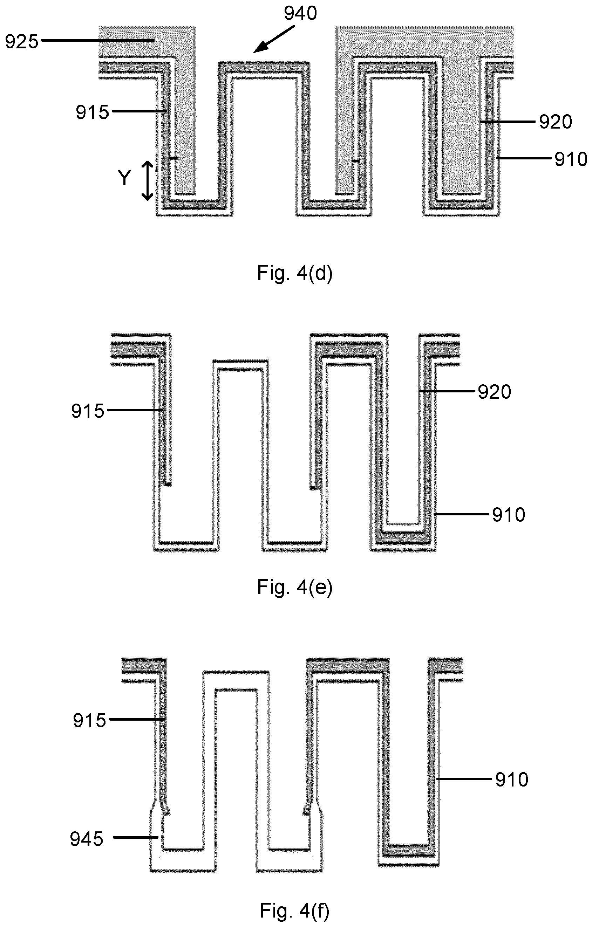

Figure 4(d) illustrates the first step of manufacturing the trenches of the semiconductor device, which is as follows:
   (d) Step 3
   - A capillary wet etch is performed on the thin oxide layer 920. The etch may be performed by immersing the whole wafer in a BOE (buffered oxide etch) such as 7:1 HF. The buffered oxide etchant etches the oxide layer 920 on the exposed mesa region 940, the exposed trench sidewalls and bottom, and the trench sidewalls extending up from the trench bottom to a desired height Y above the bottom surface of the trench.
   - The hydrophilic layer 915 creates a capillary action so that the etchant etches the oxide layer 920 along the narrow channel between the hydrophilic layer 915 itself and the photoresist 925.
   - The presence of the hydrophilic layer 915 allows control of the etch depth and uniformity of the etch process. The hydrophilic layer 915 reduces defects formed during the etch process.
Figure 4(e) illustrates the first step of manufacturing the trenches of the semiconductor device, which is as follows:
   (e) Step 4
   - The photoresist is stripped (removed) using any suitable wet or dry chemistry.
   - An etch process is performed to remove the exposed regions of the hydrophilic layer 915. The etch process can be a wet or dry etch, and stops on the initial oxide layer 910.
   - Since the hydrophilic layer 915 comprises nitride, the etch process may be done in plasma ambient using CF4/HBr chemistry.
Figure 4(f) illustrates the first step of manufacturing the trenches of the semiconductor device, which is as follows:
   (f) Step 5
   - A thick oxide layer 945 is thermally grown or deposited on the sidewalls and bottom surface of the trenches in areas without the hydrophilic layer 915 remaining. The thick oxide layer 945 may be deposited using loyal oxidation of silicon (LOCOS). The thick oxide layer 945 has a thickness of approximately 1800Å to 5000Å.

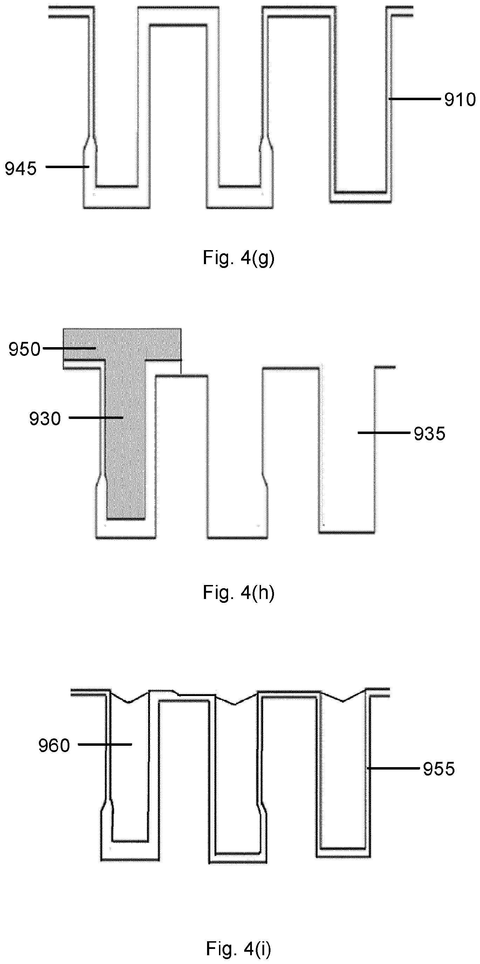

Figure 4(g) illustrates the first step of manufacturing the trenches of the semiconductor device, which is as follows:
   (g) Step 6
   - An etch process is performed to remove the remaining regions of the hydrophilic layer 915 and the remaining TEOS 920.
Figure 4(h) illustrates the first step of manufacturing the trenches of the semiconductor device, which is as follows:
   (h) Step 7
   - Photolithography is performed to apply a photoresist mask 950 that fills the active trench 930, where the mask leaves the dummy trenches 935 exposed.
   - A wet etch process is performed that strips the dummy trenches 935 to the silicon layer.
Figure 4(i) illustrates the first step of manufacturing the trenches of the semiconductor device, which is as follows:
   (i) Step 8
      - A thin oxidation layer 955 is grown on the dummy trenches having a constant thickness on the sidewalls and bottom surfaces. The thin oxide 955 layer may be is grown in a furnace step at 900°C to 1100°C. The thin oxide layer 955 has thickness of approximately 500Å to 1800Å.
      - The photoresist is stripped (removed) using any suitable wet or dry chemistry.
      - Polysilicon 960 is deposited to fill the trenches. The polysilicon 960 is planarised by etching the top of the polysilicon 960 to level off with the silicon in the mesa region between the trenches.

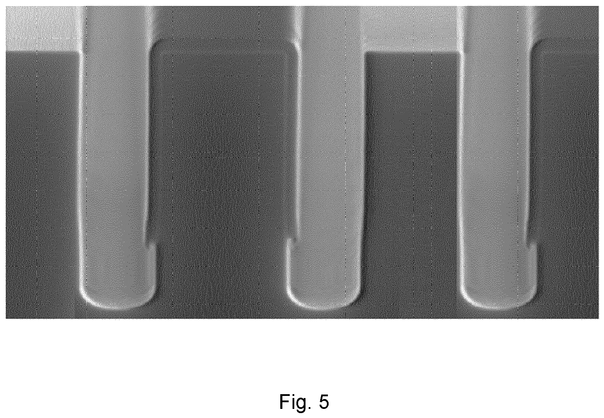

Figure 5 shows an example of a semiconductor device manufactured using the steps of Figures 4(a) to 4(h).

The skilled person will understand that in the preceding description and appended claims, positional terms such as 'above', 'overlap', 'under', 'lateral', etc. are made with reference to conceptual illustrations of an apparatus, such as those showing standard cross-sectional perspectives and those shown in the appended drawings. These terms are used for ease of reference and are therefore to be understood as referring to a device when in an orientation as shown in the accompanying drawings.

It will be appreciated that all doping polarities mentioned above could be reversed, the resulting devices still being in accordance with embodiments of the present invention.

Although the disclosure has been described in terms of preferred embodiments as set forth above, it should be understood that these embodiments are illustrative. Those skilled in the art will be able to make modifications and alternatives in view of the disclosure, which are contemplated as long as they fall within the scope of the appended claims.

## Claims

1. A method of manufacturing a semiconductor device having one or more trenches (205, 905) with an insulation layer (204), wherein the one or more trenches with an insulation layer are manufactured using the steps of:
i) performing an etching process to form the one or more trenches, whereby the trenches are formed in an upper surface of a substrate (202) extending downwards in the substrate from its upper surface;
ii) forming a first insulation layer (204) on the upper surface of the substrate and a lower surface and sidewalls of the one or more trenches;
iii) depositing a hydrophilic layer (206, 915) over the first insulation layer, wherein the hydrophilic layer comprises nitride and the hydrophilic layer has a thickness between 100nm and 250nm
iv) depositing a photoresist material (208, 925) in the one or more trenches, wherein depositing a photoresist material comprises exposing the hydrophilic layer on an upper region of a first side of the one or more trenches, leaving the hydrophilic layer not in the upper region covered with the deposited photoresist material;
v) performing a capillary wet etch process to etch the insulation layer on the sidewall of the first side of the one or more trenches to a predetermined distance below a surface of the photoresist material;
vi) removing the photoresist material;
vii) removing the hydrophilic layer; and
after performing the wet etch process, removing the photoresist material, and removing the hydrophilic layer; viii) forming a second insulation (210, 945) layer on the sidewall of the first side of the one or more trenches.

2. A method according to claim 1, wherein forming a first insulation layer comprises forming a thick insulation layer (204), and
wherein the hydrophilic layer is deposited over the thick insulation layer, and
wherein forming a second insulation layer comprises forming a thin insulation layer (210) on the sidewall of the first side of the one or more trenches, wherein the thin insulation layer is thinner than the thick insulation layer.

3. A method according to claim 1, wherein forming a first insulation layer comprises forming a thin insulation layer, and wherein forming a second insulation layer comprises forming a thick insulation layer (945) over the thin insulation layer, wherein the thin insulation layer is thinner than the thick insulation layer.

4. A method according to claim 2,
wherein the method further comprises depositing a filling material (212, 960) after growing the thin insulation layer.

5. A method according to any preceding claim, wherein the step of performing a wet etch is carried out using a buffered oxide etch, optionally wherein the buffered oxide etch comprises hydrofluoric acid.

6. A method according to any preceding claim, wherein forming the insulation layer comprises thermally growing a thick oxide layer using a local oxidation of silicon process.

7. A method according to any of claims 1 to 5, wherein forming the insulation layer comprises depositing a thick oxide layer.

8. A method according to claim 7, wherein depositing the thick oxide layer is carried out using Tetraethyl Orthosilicate, TEOS.

9. A method according to claims 2 to 8, wherein growing the thin insulation layer comprises thermally growing a thin oxide layer at 900°C to 1100°C, wherein the thin insulation layer has a thickness between 50nm and 180nm.

10. A method according to any preceding claim, wherein the insulation is asymmetric.

11. A method according to any preceding claim, wherein the insulation is symmetric, and
wherein depositing the photoresist material comprises exposing the hydrophilic layer on the upper region of two sides of the one or more trenches, and
wherein the method further comprises:
performing the capillary wet etch process to etch the insulation layer on two sidewalls of the one or more trenches to a predetermined distance below Z the surface of the photoresist material; and
growing the insulation layer on the two sidewalls of the one or more trenches.

12. A method according to any preceding claim, wherein a first trench is separated from a second trench by a mesa region between the two trenches; and
wherein the first side of the first trench is adjacent to the first side of the second trench; and
wherein depositing the photoresist material comprises exposing the hydrophilic layer in the upper region formed by mesa region between the first and second trenches

13. A method according to claim 12, wherein the method further comprises removing the hydrophilic layer in the mesa region between the two trenches.

14. A method according to claim 13, wherein removing the hydrophilic layer in the mesa region comprises removing the hydrophilic layer such that a top surface of the hydrophilic layer is recessed relative to a surface of the insulating layer deposited as a thick oxide layer

15. A method according to any of claims 12, 13, or 14, wherein the method further comprises performing the capllary wet etch process to etch the insulation layer on the mesa region.

## Patentansprüche

1. Verfahren zum Herstellen einer Halbleitervorrichtung mit einem oder mehreren Gräben (205, 905) mit einer Isolierschicht (204), wobei der eine oder die mehreren Gräben mit einer Isolierschicht unter Verwendung der folgenden Schritte hergestellt werden:
i) Durchführen eines Ätzprozesses zum Bilden des einen oder der mehreren Gräben, wodurch die Gräben in einer oberen Oberfläche eines Substrats (202) gebildet werden und sich von seiner oberen Oberfläche nach unten in das Substrat erstrecken;
ii) Bilden einer ersten Isolierschicht (204) auf der oberen Oberfläche des Substrats und einer unteren Oberfläche und Seitenwänden des einen oder der mehreren Gräben,
iii) Abscheiden einer hydrophilen Schicht (206, 915) über der ersten Isolierschicht, wobei die hydrophile Schicht Nitrid umfasst und die hydrophile Schicht eine Dicke zwischen 100 nm und 250 nm aufweist
iv) Abscheiden eines Photoresistmaterials (208, 925) in dem einen oder mehreren Gräben, wobei das Abscheiden eines Photoresistmaterials das Freilegen der hydrophilen Schicht auf einem oberen Bereich einer ersten Seite des einen oder der mehreren Gräben umfasst, wobei die hydrophile Schicht, die nicht im oberen Bereich liegt, mit dem abgeschiedenen Photoresistmaterial bedeckt bleibt;
v) Durchführen eines kapillaren Nassätzverfahrens, um die Isolierschicht auf der Seitenwand der ersten Seite des einen oder der mehreren Gräben bis zu einem vorbestimmten Abstand unterhalb einer Oberfläche des Photoresistmaterials zu ätzen;
vi) Entfernen des Photoresistmaterials;
vii) Entfernen der hydrophilen Schicht; und
nach Durchführen des Nassätzprozesses, Entfernen des Photoresistmaterials und Entfernen der hydrophilen Schicht; viii) Bilden einer zweiten Isolierschicht (210, 945) auf der Seitenwand der ersten Seite des einen oder der mehreren Gräben.

2. Verfahren nach Anspruch 1, wobei das Bilden einer ersten Isolierschicht das Bilden einer dicken Isolierschicht (204) umfasst, und
wobei die hydrophile Schicht über der dicken Isolierschicht abgeschieden wird, und
wobei das Bilden einer zweiten Isolierschicht das Bilden einer dünnen Isolierschicht (210) auf der Seitenwand der ersten Seite des einen oder der mehreren Gräben umfasst, wobei die dünne Isolierschicht dünner als die dicke Isolierschicht ist.

3. Verfahren nach Anspruch 1, wobei das Bilden einer ersten Isolierschicht das Ausbilden einer dünnen Isolierschicht umfasst, und
wobei das Bilden einer zweiten Isolierschicht das Bilden einer dicken Isolierschicht (945) über der dünnen Isolierschicht umfasst, wobei die dünne Isolierschicht dünner als die dicke Isolierschicht ist.

4. Verfahren nach Anspruch 2, wobei das Verfahren ferner das Abscheiden eines Füllmaterials (212, 960) nach dem Wachsen der dünnen Isolierschicht umfasst.

5. Verfahren nach einem der vorhergehenden Ansprüche, wobei der Schritt des Durchführens einer Nassätzung unter Verwendung einer gepufferten Oxidätzung durchgeführt wird, wobei die gepufferte Oxidätzung optional Flusssäure umfasst.

6. Verfahren nach einem der vorhergehenden Ansprüche, wobei das Bilden der Isolierschicht das thermische Wachsen einer dicken Oxidschicht unter Verwendung eines Verfahrens zur lokalen Oxidation von Silizium umfasst.

7. Verfahren nach einem der Ansprüche 1 bis 5, wobei das Bilden der Isolierschicht das Abscheiden einer dicken Oxidschicht umfasst.

8. Verfahren nach Anspruch 7, wobei das Abscheiden der dicken Oxidschicht unter Verwendung von Tetraethylorthosilikat, TEOS, ausgeführt wird.

9. Verfahren nach einem der Ansprüche 2 bis 8, wobei das Wachsen der dünnen Isolierschicht das thermische Wachsen einer dünnen Oxidschicht bei 900 °C bis 1100 °C umfasst, wobei die dünne Isolierschicht eine Dicke zwischen 50 nm und 180 nm aufweist.

10. Verfahren nach einem der vorhergehenden Ansprüche, wobei die Isolierung asymmetrisch ist.

11. Verfahren nach einem der vorhergehenden Ansprüche, wobei die Isolierung symmetrisch ist, und
wobei das Abscheiden des Photoresistmaterials das Freilegen der hydrophilen Schicht in dem oberen Bereich von zwei Seiten des einen oder mehreren Gräben umfasst, und
wobei das Verfahren ferner umfasst:
Durchführen des kapillaren Nassätzverfahren zum Ätzen der Isolierschicht auf zwei Seitenwänden des einen oder der mehreren Gräben bis zu einem vorbestimmten Abstand unterhalb der Oberfläche des Photoresistmaterials; und
Wachsen der Isolierschicht auf den beiden Seitenwänden des einen oder der mehreren Gräben.

12. Verfahren nach einem der vorhergehenden Ansprüche,
wobei ein erster Graben von einem zweiten Graben durch einen Mesa-Bereich zwischen den beiden Gräben getrennt ist, und
wobei die erste Seite des ersten Grabens an die erste Seite des zweiten Grabens angrenzt; und
wobei das Abscheiden des Photoresistmaterials das Freilegen der hydrophilen Schicht in dem oberen Bereich umfasst, der durch den Mesa-Bereich zwischen den ersten und zweiten Gräben gebildet ist.

13. Verfahren nach Anspruch 12, wobei das Verfahren ferner das Entfernen der hydrophilen Schicht aus dem Mesa-Bereich zwischen den beiden Gräben umfasst.

14. Verfahren nach Anspruch 13, wobei das Entfernen der hydrophilen Schicht in dem Mesa-Bereich das Entfernen der hydrophilen Schicht derart umfasst, dass eine obere Oberfläche der hydrophilen Schicht relativ zu einer Oberfläche der als dicke Oxidschicht abgeschiedenen Isolierschicht vertieft ist.

15. Verfahren nach einem der Ansprüche 12, 13 oder 14, wobei das Verfahren ferner das Durchführen des kapillaren Nassätzverfahrens zum Ätzen der Isolierschicht auf dem Mesa-Bereich umfasst.

## Revendications

1. Procédé de fabrication d'un dispositif à semi-conducteur présentant une ou plusieurs tranchées (205, 905) avec une couche d'isolation (204), dans lequel les une ou plusieurs tranchées avec une couche d'isolation sont fabriquées en utilisant les étapes consistant à :
i) réaliser un processus de gravure pour former les une ou plusieurs tranchées, moyennant quoi les tranchées sont formées dans une surface supérieure d'un substrat (202) et s'étendent vers le bas dans le substrat depuis sa surface supérieure ;
ii) former une première couche d'isolation (204) sur la surface supérieure du substrat et une surface inférieure et des parois latérales des une ou plusieurs tranchées ;
iii) déposer une couche hydrophile (206, 915) sur la première couche d'isolation, dans lequel la couche hydrophile comprend un nitrure et la couche hydrophile présente une épaisseur comprise entre 100 nm et 250 nm
iv) déposer un matériau photorésist (208, 925) dans les une ou plusieurs tranchées, dans lequel le dépôt d'un matériau photorésist comprend l'exposition de la couche hydrophile sur une région supérieure d'un premier côté des une ou plusieurs tranchées, en laissant la couche hydrophile qui ne se trouve pas dans la région supérieure recouverte du matériau photorésist déposé ;
v) réaliser un processus de gravure humide capillaire pour graver la couche d'isolation sur la paroi latérale du premier côté des une ou plusieurs tranchées jusqu'à une distance prédéterminée sous une surface du matériau photorésist ;
vi) enlever le matériau photorésist ;
vii) enlever la couche hydrophile ; et
après réalisation du processus de gravure humide, retrait du matériau photorésist, et retrait de la couche hydrophile ; viii) former une deuxième couche d'isolation (210, 945) sur la paroi latérale du premier côté des une ou plusieurs tranchées.

2. Procédé selon la revendication 1, dans lequel la formation d'une première couche d'isolation comprend la formation d'une couche d'isolation épaisse (204), et
dans lequel la couche hydrophile est déposée sur la couche d'isolation épaisse, et
dans lequel la formation d'une deuxième couche d'isolation comprend la formation d'une couche d'isolation mince (210) sur la paroi latérale du premier côté des une ou plusieurs tranchées, dans lequel la couche d'isolation mince est plus mince que la couche d'isolation épaisse.

3. Procédé selon la revendication 1, dans lequel la formation d'une première couche d'isolation comprend la formation d'une couche d'isolation mince, et
dans lequel la formation d'une deuxième couche d'isolation comprend la formation d'une couche d'isolation épaisse (945) sur la couche d'isolation mince, dans lequel la couche d'isolation mince est plus mince que la couche d'isolation épaisse.

4. Procédé selon la revendication 2, dans lequel le procédé comprend en outre le dépôt d'un matériau de charge (212, 960) après développement de la couche d'isolation mince.

5. Procédé selon l'une quelconque des revendications précédentes, dans lequel l'étape de réalisation d'une gravure humide est réalisée en utilisant une oxyde gravant tamponné, facultativement dans lequel l'oxyde gravant tamponné comprend de l'acide fluorhydrique.

6. Procédé selon l'une quelconque des revendications précédentes, dans lequel la formation de la couche d'isolation comprend le développement thermique d'une couche d'oxyde épaisse en utilisant un processus d'oxydation locale du silicium.

7. Procédé selon l'une quelconque des revendications 1 à 5, dans lequel la formation de la couche d'isolation comprend le dépôt d'une couche d'oxyde épaisse.

8. Procédé selon la revendication 7, dans lequel le dépôt de la couche d'oxyde épaisse est réalisée en utilisant de l'orthosilicate de tétraéthyle, TEOS.

9. Procédé selon les revendications 2 à 8, dans lequel le développement de la couche d'isolation mince comprend le développement thermique d'une couche d'oxyde mince à 900 °C à 1100 °C, dans lequel la couche d'isolation mince présente une épaisseur comprise entre 50 nm et 180 nm.

10. Procédé selon l'une quelconque des revendications précédentes, dans lequel l'isolation est asymétrique.

11. Procédé selon l'une quelconque des revendications précédentes, dans lequel l'isolation est symétrique, et
dans lequel le dépôt du matériau photorésist comprend l'exposition de la couche hydrophile sur la région supérieure de deux côtés des une ou plusieurs tranchées, et
dans lequel le procédé comprend en outre :
la réalisation du processus de gravure humide capillaire pour graver la couche d'isolation sur deux parois latérales des une ou plusieurs tranchées à une distance prédéterminée sous la surface du matériau photorésist ; et
le développement de la couche d'isolation sur les deux parois latérales des une ou plusieurs tranchées.

12. Procédé selon l'une quelconque des revendications précédentes,
dans lequel une première tranchée est séparée d'une deuxième tranchée par une région mesa entre les deux tranchées ; et
dans lequel le premier côté de la première tranchée est adjacent au premier côté de la deuxième tranchée ; et
dans lequel le dépôt du matériau photorésist comprend l'exposition de la couche hydrophile dans la région supérieure formée par la région mesa entre la première et la deuxième tranchée.

13. Procédé selon la revendication 12, dans lequel le procédé comprend en outre le retrait de la couche hydrophile dans la région mesa entre les deux tranchées.

14. Procédé selon la revendication 13, dans lequel le retrait de la couche hydrophile dans la région mesa comprend le retrait de la couche hydrophile de sorte qu'une surface supérieure de la couche hydrophile est creusée par rapport à une surface de la couche d'isolation déposée comme une couche d'oxyde épaisse.

15. Procédé selon l'une quelconque des revendications 12, 13, ou 14, dans lequel le procédé comprend en outre la réalisation du processus de gravure humide capillaire pour graver la couche d'isolation sur la région mesa.
